# EUROPEAN PATENT APPLICATION

(11) **EP 3 021 029 A1**
(43) Date of publication of application: **18.05.2016**
(21) Application number: 15194754.6
(22) Date of filing: 16.11.2015
(51) Int. Cl.: F16M 11/04

(54) **HANGER DEVICE AND ELECTRONIC DEVICE**

(30) Priority: 17.11.2014 JP 2014233158
(71) Applicant: YAMAHA CORPORATION, Hamamatsu-shi Shizuoka 430-8650 (JP)
(72) Inventor: GOTO, Yasuyoshi, Tokyo, Tokyo 107-0052 (JP); NISHIKORI, Taku, Hamamatsu-shi, Shizuoka 430-8650 (JP)
(74) Representative: Ettmayr, Andreas

(57) **Abstract**

A hanger device (11), including: a rod-like hanger (21) for hanging headphones; a casing (31, 35) configured to support the hanger such that the hanger is movable in its longitudinal direction between a storage position and a pull-out position; and a locking mechanism (22, 35, 44) disposed betrveen the casing and the hanger and configured to prohibit a movement of the hanger in the longitudinal direction when the hanger is located at the pull-out position.

## Description

### BACKGROUND OF THE INVENTION

### Technical Field

The present invention relates to a hanger device retractably holding a hanger on which headphones or the like can be temporarily hung and also relates to an electronic device, such as an audio console, equipped with the hanger device.

### Description of the Related Art

When an operator operates an audio console, there sometimes arises a need for the operator to temporarily take off headphones and to place them near the audio console. In such an occasion, it is convenient for the operator if a hanger device on which the headphones can be temporarily hung is disposed at a position near the audio console at which the operator is not hindered from operating the audio console.

Various hanger devices for temporarily hanging the headphones have been sold, such as the one configured to be fixed to an end portion of a desk with a clip or the like and the one configured to be placed on the desk.

For instance, Non Patent Literature 1 describes a headphone hanger configured to be screwed to a back surface of a main body of an electronic piano. Non Patent Literature 2 describes a hanger device configured to be fixed, by clamping, to an end portion of a desk, a shelf, and so on.

While not intended for the headphones, Non Patent Literature 3 describes, as a hanger device for hanging clothes or the like, a retractable hook including a rod-like member accommodated in a tube whose inner circumferential surface is internally threaded. The rod-like member is pushed and rotated by a hand, whereby the rod-like member can be pulled out of and retracted into the tube.

Patent Literature 1 describes a hook attached to a rod. The rod having the hook is housed in a tube, and the hook is pulled out of the tube when in use. Patent Literature 1 also describes that the tube may be bonded by a double-faced tape or may be screwed, to a shelf, a shoe cupboard or the like.

Patent Literature 1: JP-2006-341057-A
Non Patent Literature 1: Yamaha Corporation YDP-123 Owner's Manual p. 13, Internet <URL:http://www2.yamaha.co.jp/manual/pdf/emi/japan/cla/YDP123J1.pdf>
Non Patent Literature 2: audio-technica corporation Catalog Headphones 2014.Vol-2 p. 70, Intemet<URL:https://www.audio-technica.co.jp/images/cms/101/files/support/catalog/ pdf/hp_mic/hp.pdf>
Non Patent Literature 3: Nasta Co., Ltd. 2014 Architectural Hardware General Catalog p.468, Internet<URL:http://www.catalabo.org/iportal/CatalogViewInterfaceStartUpAction.do? method=startUp&mode=PAGE&catalogCategoryId=&catalogId=19093430000& pageGroupId=&volumeID=CATALABO&designID=link>

### SUMMARY OF THE INVENTION

Some of electronic devices used on a desktop, such as an audio console, a lighting console, a video editor, a portable keyboard, and a portable piano, are equipped with a fixed hanger device for hanging headphones. In particular, devices used on the desktop are desirably equipped with a detachable hanger device as described in Non Patent Literatures 2, 3 and Patent Literature 1 or a hanger device attachable to a front surface or the like of the devices, so as not to constitute an obstacle when the devices are conveyed or carried.

The detachable hanger device as described in Non Patent Literature 2, however, requires troublesome work of attaching and detaching the hanger device. Further, there may be a risk that the hanger device that has been detached may be lost when not in use. The hook described in Non Patent Literature 3 or Patent Literature 1 can be used in a state in which the hook is attached to the front surface or the like of the device. Further, the hook is convenient in that the hook can be stored in the device when the device is conveyed, for instance, so as not to hinder conveying work. The disclosed hook, however, suffers from disadvantages when applied to the device used on the desktop surface.

That is, in the electronic device configured to be used on the desktop, a position at which the headphones are hung is located forward of a table or the like on which the device is placed. Thus, the hanger for hanging the headphones needs to largely protrude from the device. Therefore, if the hanger configured to be pulled out and retracted by pushing and rotating as described in Non Patent Literature 3 is used, a time required for pulling out and retracting the hanger undesirably becomes longer. In contrast, the hanger configured to linearly slide as described in Patent Literature 1 requires a relatively short time for pulling out and retracting the hanger. However, this type of hanger tends to be easily retracted when the operator or the like comes into contact with the hanger in a state in which the hanger protrudes forward of the table or the like, causing a risk of falling of the headphones that are hung on the hanger. In the hanger devices described in Non Patent Literature 3 and Patent Literature 1, the hanger may be configured to be pushed by a spring or the like so as to be held at a pull-out position. In this case, however, there is a limit in an amount of protrusion of the hanger and a limit in a force of the spring.

In view of the situations described above, the present invention provides a hanger device having a hanger configured to be stored therein when not in use and configured to be pulled out for use, which ensures simplified work for pulling out and retracting the hanger and which prevenis the hanger from being accidentally moved, thereby preventing falling of objects that are hung on the hanger. The invention also provides an electronic device equipped with the hanger device having a hanger configured to be stored in the electronic device when not in use and configured to be pulled out for use so as to protrude from an outer surface of the electronic device.

The invention provides a hanger device, comprising: a rod-like hanger for hanging headphones; a casing that supports the hanger such that the hanger is movable in its longitudinal direction between a storage position and a pull-out position; and a locking mechanism disposed between the casing and the hanger and configured to prohibit a movement of the hanger in the longitudinal direction when the hanger is located at the pull-out position.

According to the hanger device constructed as described above, the hanger can be pulled out from and retracted into the casing by linearly moving the hanger. Thus, the hanger can be manually operated with ease. Further, the movement of the hanger in the longitudinal direction is prohibited by the locking mechanism when the hanger is located at the pull-out position at which the hanger is pulled out from the casing. Therefore, the hanger does not move even if other objects accidentally contact the hanger in a state in which the headphones or the like are hung on the hanger. It is thus possible to prevent falling of the headphones or the like from the hanger.

The invention provides an electronic device comprising the hanger device constructed as described above, wherein the hanger is stored such that the hanger is protrudable from any of outer surfaces of the electronic device.

### BRIEF DESCRIPTION OF DRAWINGS

The above and other objects, features, advantages and technical and industrial significance of the present invention will be better understood by reading the following detailed description of an embodiment of the invention, when considered in connection with the accompanying drawings, in which:
Fig. 1 is a perspective view showing an audio console equipped with hanger devices each according to one embodiment of the invention;
Fig. 2 is a front view of the audio console of Fig. 1;
Fig. 3 is a left side view of the audio console of Fig. 1;
Fig. 4 is a perspective view of the hanger device removed from the audio console of Fig. 1, the hanger device being located at a storage position;
Fig. 5 is a perspective view of the hanger device of Fig. 4 viewed from a rear side;
Fig. 6 is a top view showing a main part of the hanger device of Fig. 4;
Fig. 7 is a cross-sectional view taken along arrows A-A in Fig. 6;
Fig. 8 is a view viewed from the left side in Fig. 6;
Fig. 9 is a view viewed from the right side in Fig. 6;
Fig. 10 is a perspective view of a main part of the hanger device located at a pull-out position;
Fig. 11 is a view viewed from the top in Fig. 10;
Fig. 12 is a perspective view showing a state in which the hanger device is locked at the pull-out position;
Fig. 13 is a top view showing a main part of the hanger device of Fig. 12;
Fig. 14 is a view viewed from the left side in Fig. 13; and
Fig. 15 is a view viewed from the right side in Fig. 13.

### DETAILED DESCRIPTION OF THE EMBODIMENT

Referring to the drawings, there will be explained a hanger device according to one embodiment of the invention.

The drawings show one embodiment in which the invention is applied to a hanger device for hanging headphones and the hanger device is incorporated into an audio console (as one example of an electronic device).

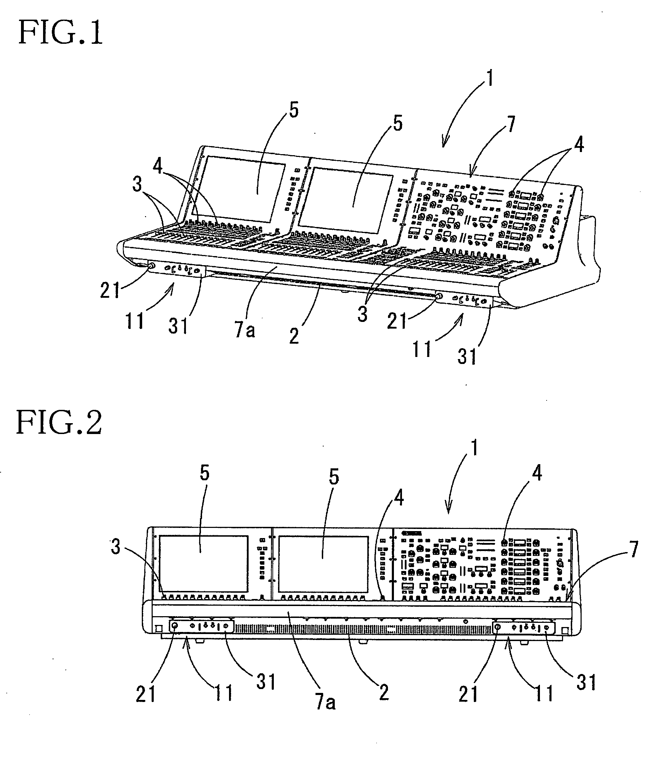

The audio console indicated at 1 in Figs. 1-3 is a mixer, for instance, and is placed on a table or the like when in use. The audio console 1 includes: a base body 2 in which a power circuit board, a control board (both not shown), and so on are housed; and an operation board 7 disposed over the based body 2 and including faders 3 for voice signal processing, operation knobs 4, displays 5 for displaying information, and so on. Audio cables or the like are detachably connected to input/output terminals 8 provided on the rear of the base body 2, whereby the audio controller 1 is connected to other audio devices via the audio cables or the like when in use.

An up-down direction (vertical direction) of the audio console 1 corresponds to an up-down direction (vertical direction) when the audio console 1 is placed on a table or the like for use. An upper side is a side on which the operation board 7 is positioned relative to the base body 2, and a lower side is opposite to the upper side. Thus, an upward direction and a downward direction are defined. When the audio console 1 is used, a user (operator) is on a front side of the operation board 7. Unless otherwise specified, the front side of the operation board 7 is referred to as a front side of the audio console 1, and a rear side of the operation board 7 is referred to as a rear side of the audio console 1. In a state in which the operator is on the front side of the audio console 1 and views the rear side from the front side, a right side is referred to as a right side of the audio console 1, and the other side (left side) is referred to as a left side of the audio console 1.

The operation board 7 is disposed so as to be inclined such that the height of the operation board 7 gradually increases from the front side toward the rear side. A front end portion 7a of the operation board 7 protrudes forward of a front end face of the base body 2 so as to function as the so-called handrest or armrest.

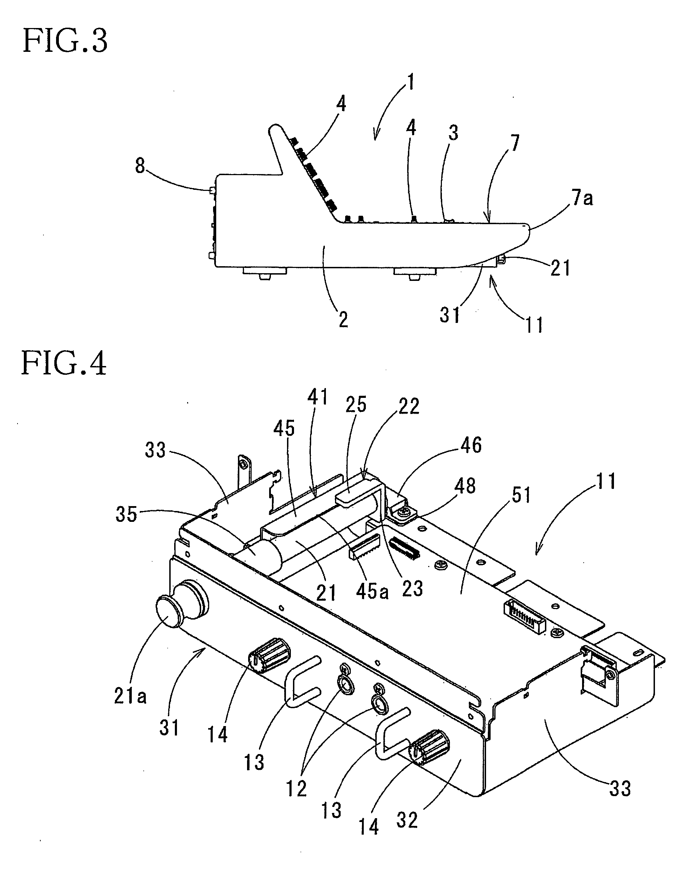

A hanger device 11 having a hanger 21 on which headphones can be hung is provided on the front end face of the base body 2 that is disposed under the front end portion 7a of the operation board 7. As shown in Fig. 4, the hanger device 11 of the present embodiment includes a box-shaped housing 31 in which the hanger 21 is disposed. Further, there are provided, on the housing 31, jacks (female terminals) 12 to each of which a plug (male terminal) of headphones are to be connected, protective guards 13 for preventing collision of other objects onto the plugs inserted in the jacks 12, and volume adjusting knobs 14 for the headphones. In the example shown in Figs. 1 and 2, the audio console 1 is equipped with two hanger devices 11 which are provided respectively at right and left end portions of the base body 2.

The hanger device of the present invention need not necessarily have the jacks 12, the protective guards 13, and the volume adjusting knobs 14.

Referring to Figs. 4-15, the hanger device 11 will be explained in detail.

The hanger device 11 includes the hanger 21 having a round-bar shape and stored in the housing 31. When the hanger 21 is stored in the housing 31, a tip portion 21a of the hanger 21 protrudes from a front end face of the housing 31 so as to be exposed. An operator grasps or holds the tip portion 21a and pulls out the hanger 21 out of the housing 31. The hanger 21 may have any shape other than the round-bar shape shown in Fig. 4. For instance, the hanger 21 may have a square-bar shape, a strip-like shape, or a bent shape obtained by bending a strip at a widthwise intermediate position thereof Further, the hanger 21 may be shaped to have a hook at a tip end thereof. That is, the hanger 21 may have various shapes as long as the headphones can be hung thereon.

The housing 31 has a rectangular shape in plan view and is shaped like a box including a front wall 32, right and left side walls 33, and a rear wall 34. A guide sleeve 35 extending in the front-rear direction of the audio console 1 is fixed at its one end to the front wall 32 so as to penetrate therethrough. The hanger 21 is inserted or disposed in the guide sleeve 35 so as to be slidable in the longitudinal direction thereof. The casing of the present invention is constituted by the guide sleeve 35 and the housing 31 in this embodiment. (The casing need not include the entirety of the housing 31, but at least includes a portion of the housing 31 that holds the guide sleeve 35 and a guide member 41 which will be explained.) As shown in Fig. 4, for instance, the guide sleeve 35 has a length slightly shorter than a front half portion of the housing 31 while the hanger 21 has a length, when stored in the housing 31, which permits a rear end of the hanger 21 to reach a magnet 46 (which will be explained) provided at the rear end of the housing 31. When the hanger 21 is stored in the housing 31, a portion of the hanger 21 having a length slightly longer than its rear half portion is exposed from the guide sleeve 35. A locking member 22 is fixed to the rear end of the hanger 21 so as to protrude sideways from the hanger 21.

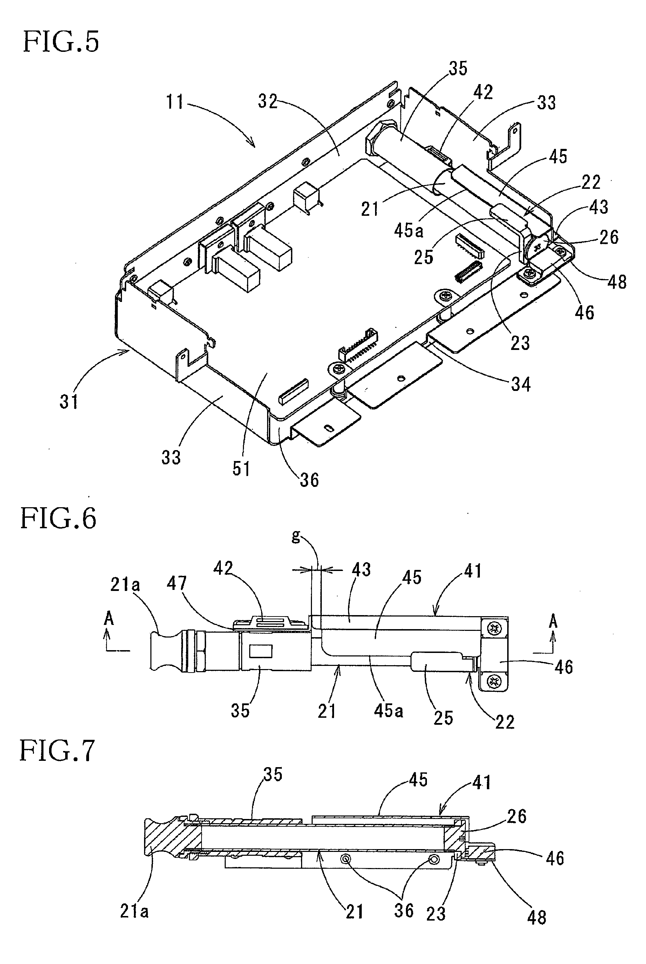

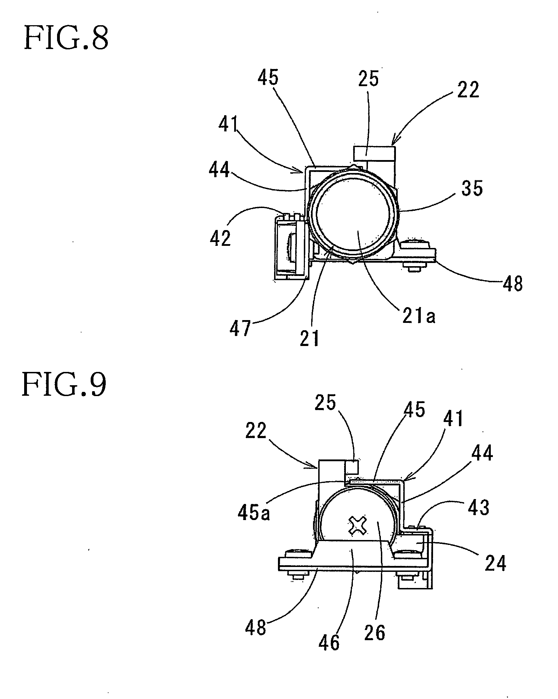

The locking member 22 is formed by bending a magnetic member such as an iron piece and is fixed at its proximal portion 23 (Fig. 7) to the rear end of the hanger 21. The locking member 22 includes the proximal portion 23, a protruding piece 24 (Fig. 9), and an extending portion 25 (Fig. 6) which are formed integrally with each other. The protruding piece 24 protrudes in a direction orthogonal to the longitudinal direction of the hanger 21, namely, protrudes in the radially outward direction. The extending portion 25 is bent at a position protruding in a direction orthogonal to the longitudinal direction of the hanger 21, so as to extend forward in the longitudinal direction of the hanger 21, namely, so as to extend in a direction from a storage position to a pull-out position (both explained later) as one example of a second movement direction. As shown in Fig. 9, the protruding piece 24 and the extending portion 25 extend in respective directions that are different relative to each other by 90° with respect to the proximal portion 23. The protruding piece 24 is parallel to the plane of the proximal portion 23. The extending portion 25 is a strip-like shape having a small width, and its substantial part is parallel to the longitudinal direction of the hanger 21. The proximal portion 23, the protruding piece 24, and the extending portion 25 of the locking member 22 may be formed separately and may be assembled to the hanger 21 individually.

A screw 26 having substantially the same outer diameter as the hanger 21 is provided at the rear end of the hanger 21 for fixing the proximal portion 23 of the locking member 22 to the hanger 21. In the present embodiment, the screw 26 is also formed of a magnetic material such as iron.

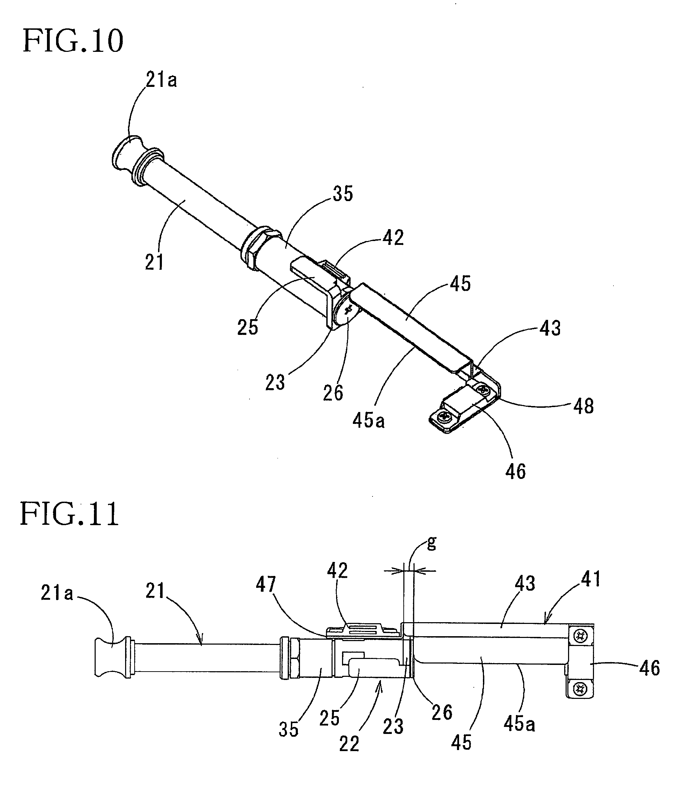

In the present embodiment, the locking member 22 formed as described above is fixed to the rear end of the hanger 21 such that the protruding piece 24 and the extending portion 25 protrude in the radially outward direction, or the proximal portion 23 of the locking member 22 has a size larger than an inner diameter of the guide sleeve 35. Owing to one of these two features, when a substantial part of the hanger 21 is pulled out from the guide sleeve 35 as shown in Figs. 10 and 11, the hanger 21 is prevented from being further pulled out at a position at which the proximal portion 23 of the locking member 22 contacts a rear end of the guide sleeve 35. That is, the rear end of the guide sleeve 35 functions as a stopper (a second stopper member) configured to contact the locking member 22 so as to prohibit a movement of the hanger 21 in the longitudinal direction, specifically in the second movement direction.

A guide member 41 is fixed to an inner surface of the side wall 33 of the housing 31. When the hanger 21 moves in the longitudinal direction, a side edge of the locking member 22 contacts the guide member 41. The guide member 41 is formed by bending a strip-like plate by 90° so as to include a plurality of steps. One side portion of the guide member 41 is fixed to the side wall 33 of the housing 31 by screwing. (In Fig. 7, holes 36 for screwing are shown.) A shelf portion 43 (Fig. 9) is formed at the one side portion so as to be bent at a suitable angle. Thus, the shelf portion 43 protrudes from the side wall 33 of the housing 31. The shelf portion 43 extends in a direction parallel to the longitudinal direction of the hanger 21. Another side portion of the guide member 41 continuous to the shelf portion 43 via a vertical wall portion 44 overhangs or protrudes over the hanger 21 so as to provide an overhanging portion 45 which will be explained. (The vertical wall portion 44 is one example of a stopper or a first stopper member.) The shelf portion 43 is disposed sideways of the hanger 21.

A strip-like base 47 is provided at a front end of the guide member 41, and a strip-like base 48 is provided at a lower portion of a rear end of the guide member 41. Each base 47, 48 is formed so as to be bent from the corresponding front or rear end of the guide member 41. To the front-end base 47 (Fig. 6), a magnet 42 for attracting the locking member 22 is screwed. To the rear-side base 48 (Figs. 4, 5, and 7), the magnet 46 for attracting the proximal portion 23 and the screw 26 is screwed. The magnets 42, 46 may be fixed directly to the side wall 33 and the rear wall 34 of the housing 31, respectively, not via the bases 47,48. The magnets 42, 46 may be fixed by bonding or the like other than by screwing.

The overhanging portion 45 protruding over the hanger 21 is disposed such that its distal edge 45 extends substantially just over the hanger 21 linearly along the longitudinal direction (sliding direction) of the hanger 21.

The hanger 21 is disposed relative to the guide member 41 in the following positional relationship. That is, in a state in which the extending portion 25 of the locking member 22 of the hanger 21 is disposed over the hanger 21, a side edge of a proximal end portion of the extending portion 25 is held in contact with the distal edge 45a of the overhanging portion 45 of the guide member 41. Therefore, in an instance where the locking member 22 is disposed within a length range of the overhanging portion 45 of the guide member 41, the hanger 21 is prohibited from rotating in a direction in which the locking member 22 pushes the guide member 41. In other words, rotation of the hanger 21 in a counterclockwise direction in Fig. 8 (as one example of a first rotational direction) and in a clockwise direction in Fig. 9 is prohibited.

In the state in which the extending portion 25 of the locking member 22 is disposed over the hanger 21, the protruding piece 24 that protrudes from the proximal portion 23 at an angle of 90° with respect to the extending portion 25 is located under the shelf portion 43 of the guide member 41, as shown in Fig. 9. That is, the shelf portion 43 is located over the protruding piece 24. Thus, the hanger 21 is prohibited from rotating in a direction in which the locking member 22 moves away from the guide member 41. In other words, rotation of the hanger 21 in a clockwise direction in Fig. 8 (as one example of a second rotational direction) and in a counterclockwise direction in Fig. 9 is prohibited.

Consequently, in a state in which the locking member 22 is held in contact with the distal edge 45a of the guide member 41, the hanger 21 is prohibited from rotating in both of clockwise and counterclockwise directions. That is, when the hanger 21 is located between a storage position and a pull-out position (both will be later explained), the hanger 21 is prohibited from rotating in both of the clockwise and counterclockwise directions in Fig. 8, so that the hanger 21 is guided by the guide member 41 in the longitudinal direction in a state in which a rotational position of the hanger 21 about a rotation axis extending along the longitudinal direction is kept at a predetermined position (first rotational position).

The guide member 41 has a length set such that, when the locking member 22 of the hanger 21 is pulled out to a position at which the locking member 21 is close to or comes into contact with the rear end of the guide sleeve 35, the proximal portion 23 including the proximal end portion of the extending portion 25 of the locking member 22 is located forward of a front end of the overhanging portion 45 of the guide member 41. As shown in Fig. 6, there is formed a clearance g between the front end of the overhanging portion 45 of the guide member 41 and the rear end of the guide sleeve 35. When the hanger 21 is pulled out, the proximal portion 23 of the locking member 22 is disposed in the clearance g. In this respect, the shelf portion 43 has a length larger than the overhanging portion 45. That is, the shelf portion 43 extends forward of the overhanging portion 45 and substantially reaches the rear end of the guide sleeve 35. Hence, even when the proximal end portion of the extending portion 25 of the locking member 22 extends forward of and accordingly disengages from the front end of the overhanging portion 45, the protruding piece 24 is kept located under the shelf portion 43.

Each of Figs. 10 and 11 shows a state in which the hanger 21 is pulled out to a position at which the proximal portion 23 including the proximal end portion of the extending portion 25 of the locking member 22 is located forward of and disengages from the front end of the overhanging portion 45. A left-side view and a right-side view for Fig. 11 are similar to the left side view (Fig. 8) and the right side view (Fig. 9) for Fig. 6.

As shown in Figs. 10 and 11, when the proximal end portion of the extending portion 25 of the locking member 22 disengages from the overhanging portion 45 of the guide member 41, the proximal portion 23 including the proximal end portion of the extending portion 25 is disposed in the clearance g between the front end of the overhanging portion 45 of the guide member 41 and the rear end of the guide sleeve 35. In this instance, a substantial part of the extending portion 25 of the locking member 22 is disposed outward of the guide sleeve 35, namely, over the guide sleeve 35 in Figs. 10 and 11. At this position, therefore, a substantially half portion of the proximal portion 23 including the proximal end portion of the extending portion 25 of the locking member 22 (i.e., a substantially upper half portion thereof above the protruding piece 24 shown in Fig. 9) does not interfere with the overhanging portion 45 of the guide member 41. However, the protruding piece 24 is kept disposed under the shelf portion 43, so that rotation of the hanger 21 in the clockwise direction in Fig. 8 (i.e., in the counterclockwise direction in Fig. 9) is prohibited whereas rotation of the hanger 21 in the counterclockwise direction in Fig. 8 (i.e., in the clockwise direction in Fig. 9) is allowed. That is, when the hanger 21 is located at the pull-out position, the hanger 21 is not prohibited from rotating in the counterclockwise direction in Fig. 8 (as one example of a first rotational direction).

The pull-out position of the hanger 21 is defined as a position at which the extending portion 25 of the locking member 22 does not interfere anymore with the guide member 41 after the hanger 21 having being pulled out (i.e., a position at which the proximal portion 23 of the locking member 22 contacts the rear end of the guide sleeve 35 or a position at which the proximal end portion of the extending portion 25 disengages from the overhanging portion 45, namely, a position at which the proximal portion 23 of the locking member 22 is disposed in the clearance g).

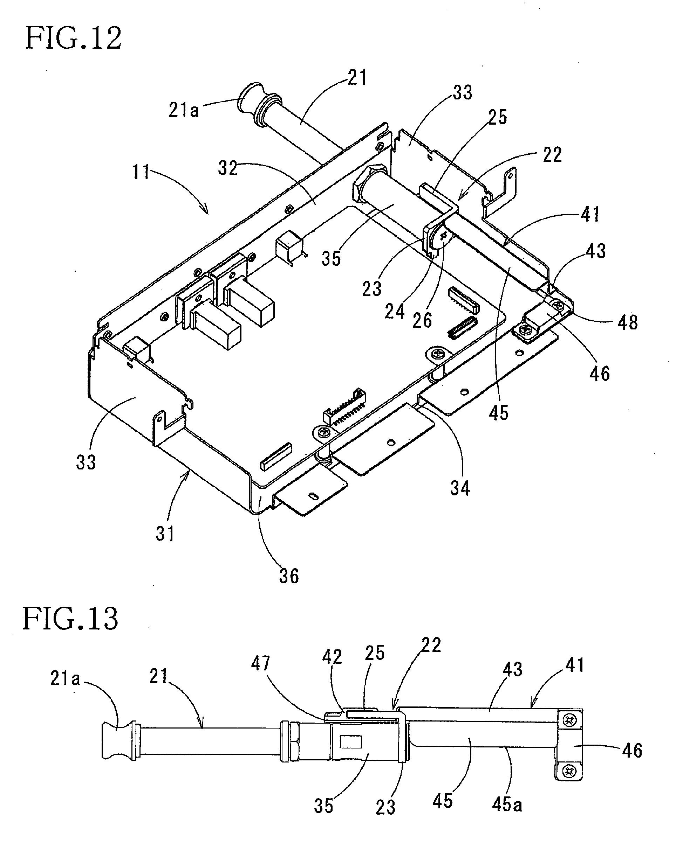

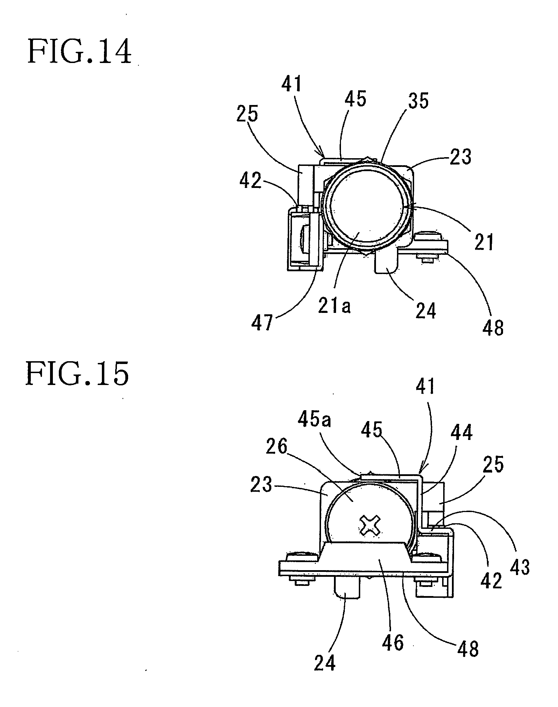

The magnet 42 is located nearer to the front wall 32 of the housing 31 than the guide member 41 and is disposed at a forward position in the rotational direction of the locking member 22 when the hanger 21 is located at the pull-out position. (In the example of Fig. 5 and so on, the magnet 42 is disposed sideways of the rear end of the guide sleeve 35.) When the hanger 21 is rotated in the counterclockwise direction in Fig. 8 in a state in which the hanger 21 is located at the pull-out position, the locking member 22 comes into contact with the magnet 42 and the magnet 42 can attract the locking member 22, as shown in Figs. 12-15. That is, when the hanger 21 is located at the pull-out position, the hanger 21 can rotate from the predetermined position (the first rotational position) at which hanger 21 has been guided by the guide member 41 to another predetermined position (as one example of a second rotational position) at which the locking member 22 contacts the magnet 42. The magnet 42 functions as a holder for holding the hanger 21 at the predetermined position (the second rotational position) by attracting the locking member 22 of the hanger 21. In the state in which the locking member 22 is attracted by the magnet 42, the locking member 22 is located forward of the overhanging portion 45 of the guide member 41, and part (the proximal end portion) of the extending portion 25 of the locking member 22 extends across the front side of the vertical wall portion 44 of the guide member 41 that connects the shelf portion 43 and the overhanging portion 45, as shown in Fig. 15. Thus, even if the hanger 21 is pushed rearward against the attraction force of the magnet 42, the locking member 22 is kept attracted by the magnet 42, and the part (the proximal end portion) of the extending portion 25 of the locking member 22 is in contact with the front end of the vertical wall portion 44 of the guide member 41. Thus, the hanger 21 is prohibited from moving rearward, namely, a movement of the hanger 21 in the rearward direction (as one example of a first movement direction) is prohibited. In other words, a pull-out side locking mechanism is constituted by the guide sleeve 35 through which the hanger 21 extends (specifically, the rear end of the guide sleeve 35), the guide member 41 fixed to the side wall 33 of the housing 31 (specifically, the front ends of the overhanging portion 45 and the vertical wall portion 44), the magnet 42, and the locking member 22 of the hanger 21. The pull-out side locking mechanism is for prohibiting the movement of the hanger 21 when the hanger 21 is pulled out and holding the hanger 21 at the pull-out position. In the pull-out side locking mechanism, the vertical wall portion 44 of the guide member 41 functions as a stopper (or a first stopper member) configured to contact the locking member 22 and to prohibit the hanger 21 from moving rearward when the hanger 21 is located at the pull-out position.

At the rear end of the housing 31, the magnet 46 is provided as shown in Figs. 4, 5, and so on. When the hanger 21 is pushed into the housing 31 and is stored therein, namely, when the hanger 21 is located at the storage portion, the magnet 46 attracts the proximal portion 23 of the locking member 22 or the screw 26 that comes into contact with the magnet 46. A storage-side locking mechanism is constituted by the magnet 46 provided at the rear end of the housing 31, the proximal portion 23 of the locking member 22 of the hanger 21, or the screw 26. The storage-side locking mechanism is for prohibiting the movement of the hanger 21 when the hanger 21 is pushed into and stored in the housing 31. As explained above, the screw 26 having substantially the same outer diameter as that of the hanger 21 is attached to the rear end of the hanger 21 and is formed of the magnetic material. The screw 26 may be formed of a non-magnetic material such as aluminum depending on the shape, the size, the position to which the screw 26 is attached, etc. In this case, the proximal portion 23 of the locking member 22 is attracted by the magnet 46. The locking member 22 may be fixed to the hanger 21 by reveting, welding, bonding or the like other than by using the screw 26.

The tip portion 21a of the hanger 21 that protrudes from the front wall 32 of the housing 31 when the hanger 21 is located at the storage position is preferably shaped like a knob for enabling the operator to easily grasp the tip portion 21a. Reference numeral 51 in the drawings indicates a circuit board housed in the housing 31.

The audio console 1 equipped with the thus constructed hanger devices 11 is placed on a table or the like when used. The audio console 1 can be conveyed when set up at different positions.

When the audio console 1 is conveyed, the hanger 21 is stored in the housing 31 as shown in Figs. 4-9 and is attracted by the magnet 46 of the storage-side locking mechanism, whereby the hanger 21 is locked at the storage position so as not to move forward.

For hanging headphones on the hanger 21 in a state in which the audio console 1 is placed on a table or the like, the operator grasps and pulls out the tip portion (knob) 21a of the hanger 21, whereby the hanger 21 is detached from the magnet 46 and is pulled out forward of the housing 31 so as to protrude from the base body 2. The pull-out operation is conducted in a state in which the side edge of the proximal end portion of the extending portion 25 of the locking member 22 is in contact with the distal edge 45a of the overhanging portion 45 of the guide member 41 and the protruding piece 24 of the locking member 22 is disposed under the shelf portion 43 of the guide member 41 and in a state in which the hanger 21 is inserted in the guide sleeve 35. As a result, the hanger 21 is guided linearly along the longitudinal direction of the guide member 41 without rotating in either the clockwise direction or the counterclockwise direction. As shown in Figs. 10 and 11, when the hanger 21 is pulled out to the frontmost position, the extending portion 25 of the locking member 22 is disengaged from the guide member 41, so that the hanger 21 can rotate in the counterclockwise direction in Fig. 8. By rotating the hanger 21 in the counterclockwise direction in Fig. 8, the locking member 22 comes into contact with the magnet 42 fixed to the side wall 33 of the housing 31 and is attracted by the magnet 42, as shown in Figs. 12-15.

At the pull-out position, the hanger 21 largely protrudes on the front side of the audio console 1, and the headphones can be hung on the protruded portion of the hanger 21. At the pull-out position, the locking member 22 is attracted by the magnet 42, and the extending portion 25 extends across the front side of the vertical wall portion 44 of the guide member 41, whereby the hanger 21 is locked at the pull-out position and is prevented from moving even if the hanger 21 is pushed in a direction in which the hanger 21 is retracted. In this instance, because the locking member 22 of the hanger 21 is attracted by the magnet 42, the hanger 21 is prohibited from rotating in the second rotational direction. It is thus possible to prevent, with high reliability, an occurrence of accidental release of the lock due to vibration or the like.

It is to be understood that the invention is not limited to the details of the illustrated embodiment, but may be otherwise embodied with various modifications within the scope of the invention.

In the illustrated embodiment, the hanger device is incorporated as a part of the audio console. Principal components such as the hanger 21 and the guide member 41 of the hanger device shown in Figs. 6-9, Figs. 10-11, and Figs. 13-15 may be separately prepared from the audio console 1 so as to be independent therefrom and may be incorporated into the casing, as a unit device, configured to hold the hanger 21 such that the hanger 21 is movable in the longitudinal direction between the storage position and the pull-out position. The thus formed unit may be used as a product adaptable to various electronic devices including the audio console of the illustrated embodiment

In the illustrated embodiment, the hanger device is incorporated in the electronic device such that the hanger protrudes from the front surface of the electronic device. The hanger device may be incorporated in the electronic device such that the hanger protrudes from both side surfaces or from the rear surface of the electronic device. Each of the front surface, both side surfaces, the rear surface, and the upper surface of the electronic device is one example of an outer surface of the electronic device.

The invention provides a hanger device, comprising: a rod-like hanger for hanging headphones; a casing that supports the hanger such that the hanger is movable in its longitudinal direction between a storage position and a pull-out position; and a locking mechanism disposed between the casing and the hanger and configured to prohibit a movement of the hanger in the longitudinal direction when the hanger is located at the pull-out position.

According to the hanger device constructed as described above, the hanger can be pulled out from and retracted into the casing by linearly moving the hanger. Thus, the hanger can be manually operated with ease. Further, the movement of the hanger in the longitudinal direction is prohibited by the locking mechanism when the hanger is located at the pull-out position at which the hanger is pulled out from the casing. Therefore, the hanger does not move even if other objects accidentally contact the hanger in a state in which the headphones or the like are hung on the hanger. It is thus possible to prevent falling of the headphones or the like from the hanger.

In the hanger device constructed as described above, the hanger may be supported by the casing so as to be rotatable between a first rotational position and a second rotational position about an axis along the longitudinal direction when the hanger is located at the pull-out position, and the locking mechanism may prohibit the movement of the hanger in the longitudinal direction when the hanger is located at the pull-out position and a rotational position of the hanger is the second rotational position.

In the hanger device constructed as described above the locking mechanism may allow the movement of the hanger in the longitudinal direction when the hanger is located at the pull-out position and a rotational position of the hanger is the first rotational position by rotation of the hanger in a second rotational direction that is opposite to the first rotational direction and that is directed from the second rotational position to the first rotational position.

In the hanger device constructed as described above, the casing may include a guide member configured such that: when the hanger is located between the storage position and the pull-out position, the guide member guides the hanger in the longitudinal direction in a state in which the guide member prohibits the hanger from rotating at least in the first rotational direction about the axis along the longitudinal direction; and when the hanger is located at the pull-out position, the guide member does not prohibit the hanger from rotating in the first rotational direction.

According to the hanger device constructed as described above, the hanger is pulled out from and retracted into the casing while being guided by the guide member, so that the hanger can be manually operated with ease.

In the hanger device constructed as described above, the guide member may be configured such that, when the hanger is located between the storage position and the pull-out position, the guide member guides the hanger such that the hanger is kept at the first rotational position.

In the hanger device constructed as described above, the locking mechanism may include: a locking member fixed to the hanger and protruding in a direction orthogonal to the longitudinal direction; and a stopper provided in the casing.

In the hanger device constructed as described above, the stopper may include: a first stopper member configured to come into contact with the locking member so as to prohibit a movement of the hanger in a first movement direction which is along the longitudinal direction and which is a direction from the pull-out position toward the storage position; and a second stopper member configured to come into contact with the locking member so as to prohibit a movement of the hanger in a second movement direction which is along the longitudinal direction and which is a direction from the storage position toward the pull-out position.

In the hanger device constructed as described above, the stopper may be located rearward of the locking member when the hanger is located at the pull-out position and the rotational position of the hanger is the second rotational position.

According to the hanger device constructed as described above, when the hanger is pulled out forward to the pull-out position and is rotated, the hanger is prohibited moving rearward by the stopper and is kept located or locked at the pull-out position with high reliability.

In the hanger device constructed as described above, the locking member may be configured such that: when the hanger is located at the pull-out position and the rotational position of the hanger is the first rotational position, the locking member does not contact the first stopper member; and when the hanger is located at the pull-out position and the rotational position of the hanger is the second rotational position, the locking member contacts the first stopper member so as to prohibit the movement of the hanger in the first movement direction.

In the hanger device constructed as described above, the locking member may be configured such that, when the hanger is located at the pull-out position and both of when the rotational position of the hanger is the first rotational position and when the rotational position of the hanger is the second rotational position, the locking member contacting the second stopper member so as to prohibit the movement of the hanger in the second movement direction.

In the hanger device constructed as described above, the hanger may include an attracting mechanism configured to fix the casing and the hanger to each other by magnetic force such that, when the hanger is located at the pull-out position, the hanger is held at the second rotational position.

Since the hanger that has been locked needs to be rotated to release the lock, the lock is not released unintendedly as long as the hanger is handled in a normal way. Nevertheless, the thus constructed hanger device enables the locking state of the hanger to be maintained by the magnetic force, so that it is possible to prevent an occurrence of accidental release of the lock due to vibration or the like.

The hanger device constructed as described above may further comprise a storage-side locking mechanism disposed between the casing and the hanger and configured to prohibit the movement of the hanger in the longitudinal direction when the hanger is located at the storage position.

The hanger is locked in a state in which the hanger is stored in the casing, so that it is possible to prevent the hanger from unintendedly protruding when an electronic device, on which the hanger device is mounted, is conveyed, for instance.

The invention provides an electronic device comprising the hanger device constructed as described above, wherein the hanger is stored such that the hanger is protrudable from any of outer surfaces of the electronic device.

## Claims

1. A hanger device (11), comprising:
a rod-like hanger (21) for hanging headphones;
a casing (31, 35) that supports the hanger such that the hanger is movable in its longitudinal direction between a storage position and a pull-out position; and
a locking mechanism (22,35,44) disposed between the casing and the hanger and configured to prohibit a movement of the hanger in the longitudinal direction when the hanger is located at the pull-out position.

2. The hanger device (11) according to claim 1,
wherein the hanger (21) is supported by the casing (31, 35) so as to be rotatable between a first rotational position and a second rotational position about an axis along the longitudinal direction when the hanger is located at the pull-out position, and
wherein the locking mechanism (22, 35, 44) prohibits the movement of the hanger in the longitudinal direction when the hanger is located at the pull-out position and a rotational position of the hanger is the second rotational position by rotation of the hanger in a first rotational direction directed from the first rotational position to the second rotational position.

3. The hanger device (11) according to claim 1, wherein the locking mechanism (22, 35, 44) allows the movement of the hanger (21) in the longitudinal direction when the hanger is located at the pull-out position and a rotational position of the hanger is the first rotational position by rotation of the hanger in a second rotational direction that is opposite to the first rotational direction and that is directed from the second rotational position to the first rotational position.

4. The hanger device (11) according to claim 2, wherein the casing (31, 35) includes a guide member (41, 43, 45) configured such that:
when the hanger is located between the storage position and the pull-out position, the guide member guides the hanger (21) in the longitudinal direction in a state in which the guide member prohibits the hanger from rotating at least in the first rotational direction about the axis along the longitudinal direction; and
when the hanger is located at the pull-out position, the guide member does not prohibit the hanger from rotating in the first rotational direction.

5. The hanger device (11) according to claim 4, wherein the guide member (41, 43, 45) is configured such that, when the hanger (21) is located between the storage position and the pull-out position, the guide member guides the hanger such that the hanger is kept at the first rotational position.

6. The hanger device (11) according to claim 2, wherein the locking mechanism (22, 35, 44) includes: a locking member (22) fixed to the hanger (21) and protruding in a direction orthogonal to the longitudinal direction; and a stopper (35, 44) provided in the casing.

7. The hanger device (11) according to claim 6, wherein the stopper (35, 44) includes: a first stopper member (44) configured to come into contact with the locking member (22) so as to prohibit a movement of the hanger (21) in a first movement direction which is along the longitudinal direction and which is a direction from the pull-out position toward the storage position; and a second stopper member (35) configured to come into contact with the locking member so as to prohibit a movement of the hanger in a second movement direction which is along the longitudinal direction and which is a direction from the storage position toward the pull-out position.

8. The hanger device (11) according to claim 6, wherein the stopper (44) is located rearward of the locking member (22) when the hanger (21) is located at the pull-out position and the rotational position of the hanger is the second rotational position.

9. The hanger device (11) according to claim 7, wherein the locking member (22) is configured such that:
when the hanger (21) is located at the pull-out position and the rotational position of the hanger is the first rotational position, the locking member does not contact the first stopper member (44); and
when the hanger is located at the pull-out position and the rotational position of the hanger is the second rotational position, the locking member contacts the first stopper member so as to prohibit the movement of the hanger in the first movement direction.

10. The hanger device (11) according to claim 9, wherein the locking member (22) is configured such that, when the hanger (21) is located at the pull-out position and both of when the rotational position of the hanger is the first rotational position and when the rotational position of the hanger is the second rotational position, the locking member contacts the second stopper member (35) so as to prohibit the movement of the hanger in the second movement direction.

11. The hanger device (11) according to claim 2, wherein the hanger (21) includes an attracting mechanism (22, 42) configured to fix the casing and the hanger to each other by magnetic force such that, when the hanger is located at the pull-out position, the hanger (21) is held at the second rotational position.

12. The hanger device (11) according to any one of claims 1-11, further comprising a storage-side locking mechanism (23, 26, 46) disposed between the casing (31, 35) and the hanger (21) and configured to prohibit the movement of the hanger in the longitudinal direction when the hanger is located at the storage position.

13. An electronic device (1) comprising the hanger device (11) defined in any one of claims 1-12, wherein the hanger (21) is stored such that the hanger is protrudable from any of outer surfaces of the electronic device.
